# EUROPEAN PATENT APPLICATION

(11) **EP 4 835 870 A1**
(43) Date of publication of application: **04.11.2026**
(21) Application number: 26169811.2
(22) Date of filing: 31.03.2026
(51) Int. Cl.: G09G 3/20, G09G 3/34, G11C 19/28

(54) **ELECTRONIC PAPER DISPLAY, GATE DRIVER ON ARRAY CIRCUIT, AND SINGLE STAGE CIRCUIT THEREOF**

(30) Priority: 02.05.2025 US 202563798580 P
(71) Applicant: E Ink Holdings Inc., 30078 Hsinchu (TW)
(72) Inventor: WU, Chi-Liang, HSINCHU (TW); CHEN, Wei-Tsung, HSINCHU (TW); KUO, Chia Hao, HSINCHU (TW); CHANG, Chun Kai, HSINCHU (TW)
(74) Representative: Winter, Brandl - Partnerschaft mbB

(57) **Abstract**

A single-stage circuit (111) for Electronic Paper Display (EPD) technology comprising an input unit (111a), an output unit (111c), and an intermediate circuit (111b). The input unit (111a) receives a set signal (SET) and controls a first node (P) and a second node (X) to have a first voltage (V1) and a second voltage (V2), respectively. The output unit (111c) provides a clock signal (CLK) to an output terminal (G(N)) according to the first voltage (V1), and blocks a system low voltage (VGL) from the output terminal (G(N)) according to the second voltage (V2). The intermediate circuit (111b) includes three transistors (T1), (T2), (T3), wherein a product of a width-to-length ratio of the first transistor (T1) and a positive integer coefficient (k) is smaller than a sum of width-to-length ratios of the second transistor (T2) and the third transistor (T3).

## Description

### BACKGROUND

### Technical field

The present disclosure relates to display technology, and more particularly to a Gate Driver on Array (GOA) circuit and a single stage circuit thereof suitable for Electronic Paper Display (EPD) technology.

### Description of Prior Art

In Electronic Paper Displays (EPDs), pixel circuits are typically driven by a high voltage to improve the contrast of display particles and the refresh rate. Meanwhile, using Gate Driver on Array (GOA) circuit reduces the costs associated with external gate driver chips.

Since the entire GOA circuit is composed of hundreds or even thousands of cascaded single-stage circuits (depending on the screen resolution) and must operate under high voltage conditions, the potential distribution of various critical nodes within each single stage circuit is crucial. As the operating voltage increases, the current flowing through the components of the single-stage circuit also increases. If the potential distribution among the nodes is uneven or the timing control is poor, this may cause node voltage deviation and generate short circuit currents, resulting in distortion of the output waveforms.

### DISCLOSURE OF THE INVENTION

Accordingly, the present disclosure provides a single-stage circuit. The single-stage circuit includes an input unit, an output unit, and an intermediate circuit. The input unit is configured to receive a set signal within a set interval, and control a first node to have a first voltage and a second node to have a second voltage in response to the set signal. The output unit is configured to receive a clock signal and a system low voltage, provide the clock signal to an output terminal of the output unit in response to the first voltage, and block the system low voltage from the output terminal in response to the second voltage. The intermediate circuit is coupled between the input unit and the output unit and includes a first transistor, a second transistor, and a third transistor. A first terminal and a control terminal of the first transistor are coupled to a system high voltage, and a second terminal of the first transistor is coupled to the second node. A control terminal of the second transistor receives the set signal, a first terminal of the second transistor is coupled to the second node, and a second terminal of the second transistor is coupled to the system low voltage. A control terminal of the third transistor is coupled to the first node, a first terminal of the third transistor is coupled to the second node, and a second terminal of the third transistor is coupled to the system low voltage. A product of a width-to-length ratio of the first transistor and a coefficient is smaller than a sum of a width-to-length ratio of the second transistor and a width-to-length ratio of the third transistor, and the coefficient is a positive integer.

According to one embodiment of the present disclosure, the coefficient is greater than or equal to 30.

According to one embodiment of the present disclosure, a potential at the second node decreases to the second voltage before a potential at the first node increases to the first voltage.

According to one embodiment of the present disclosure, during a reset interval, the potential of the first node decreases from the first voltage to a third voltage, the potential of the second node increases from the second voltage to a fourth voltage, and the potential of the first node decreases to the third voltage before the potential of the second node increases to the fourth voltage.

According to one embodiment of the present disclosure, during the set interval, the first transistor has a first equivalent impedance, the second transistor has a second equivalent impedance, the third transistor has a third equivalent impedance, and a parallel value of the second equivalent impedance and the third equivalent impedance is significantly smaller than the first equivalent impedance.

According to one embodiment of the present disclosure, the input unit includes a set transistor. A control terminal and a first terminal of the set transistor are coupled to the set signal, and a second terminal of the set transistor is coupled to the first node.

According to one embodiment of the present disclosure, the input unit includes a reset transistor. A control terminal of the reset transistor is coupled to a reset signal, a first terminal of the reset transistor is coupled to the first node, and a second terminal of the reset transistor is coupled to the system low voltage.

According to one embodiment of the present disclosure, the output unit includes a pull-up transistor. A control terminal of the pull-up transistor is coupled to the first node, a first terminal of the pull-up transistor is coupled to the clock signal, and a second terminal of the pull-up transistor is coupled to the output terminal.

According to one embodiment of the present disclosure, the output unit includes a pull-down transistor. A control terminal of the pull-down transistor is coupled to the second node, a first terminal of the pull-down transistor is coupled to the output terminal, and a second terminal of the pull-down transistor is coupled to the system low voltage.

According to one embodiment of the present disclosure, the intermediate circuit further includes a fourth transistor. A control terminal of the fourth transistor is coupled to the second node, a first terminal of the fourth transistor is coupled to the first node, and a second terminal of the fourth transistor is coupled to the system low voltage.

The present disclosure provides an electronic paper display. The electronic paper display includes a display panel and a gate driver on array circuit. The gate driver on array circuit is configured to drive the display panel and includes multiple single-stage circuits as described in any one of the foregoing, and these single-stage circuits are electrically connected in series with each other.

The present disclosure provides a gate driver on array circuit. The gate driver on array circuit includes multiple circuit stages. These circuit stages are electrically connected in series with one another, and each of the circuit stages includes a single-stage circuit as described in any one of the foregoing.

### BRIEF DESCRIPTION OF THE DRAWINGS

For a clearer and easier understanding of the above and other objects, features, advantages, and embodiments of the present disclosure, the drawings are described below.
Fig. 1 is a schematic diagram of an electronic paper display according to an embodiment of the present disclosure.
Fig. 2 is a schematic diagram of an N^{th} single-stage circuit according to an embodiment of the present disclosure.
Fig. 3 is a timing diagram of the states corresponding to a single-stage circuit according to an embodiment of the present disclosure.
Fig. 4 is a schematic diagram of an equivalent circuit of a single-stage circuit during a set interval according to an embodiment of the present disclosure.
Fig. 5 is a schematic diagram of an equivalent impedance model in the set interval based on the equivalent circuit illustrated in Fig. 4.

### DETAILED DESCRIPTION

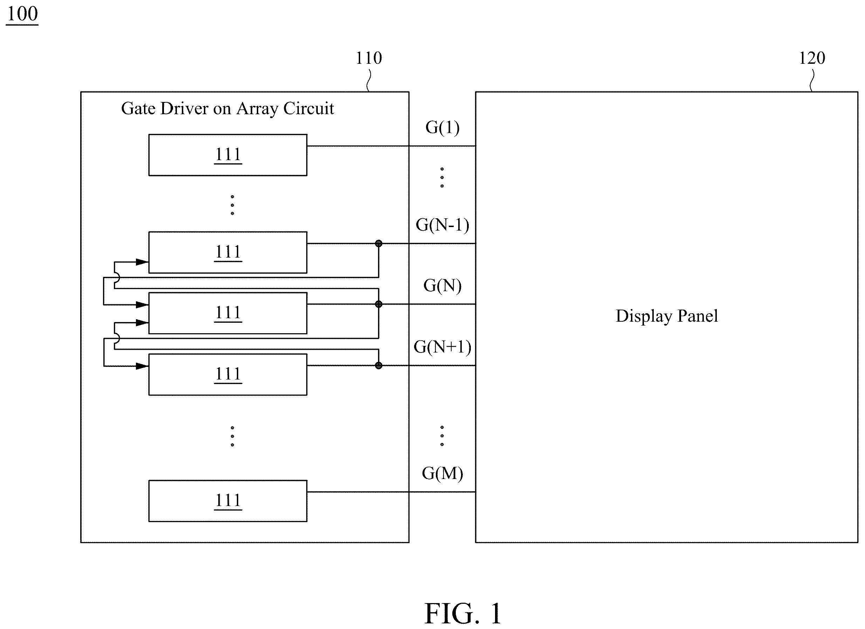

Referring to Fig. 1, Fig. 1 is a schematic diagram of an electronic paper display 100 according to an embodiment of the present disclosure. The electronic paper display (100) includes a Gate Driver on Array (GOA) circuit (110) and a display panel (120). The display panel (120) includes multiple pixel circuits (not shown) arranged in rows and columns. The GOA circuit (110) sequentially supplies multiple scanning signals to multiple columns of pixel circuits on display panel (120), thereby sequentially activating these pixel circuits column by column.

The electronic paper display (100) further includes associated control circuits, such as a data driver circuit (not shown), a timing controller (not shown) and a power supply circuit (not shown). The data driver circuit generates the corresponding data signals based on the input image data. These data signals are then output to the display panel (120) to control the pixel circuits for displaying corresponding grayscales or color levels. The timing controller generates and synchronizes various control signals to coordinate the timing of operations between the GOA circuit (110) and the data driver circuit. The power supply circuit provides multiple voltage levels required for the operations of the circuits, including gate scanning voltages, data voltages, and reference voltages.

With the above configurations, the electronic paper display (100) can perform screen scanning and data writing operations. It can also be used in e-book readers, flexible display devices, and other electrophoretic display technology applications.

The GOA circuit (110) includes cascaded circuit stages. Each circuit stage includes a single-stage circuit (111). The outputs (G(1)), ..., (G(N-1)), (G(N)), (G(N+1)), ..., and (G(M)) of these single-stage circuits (111) couple to the pixel circuits and sequentially provide the scanning signals to them.

For example, during period N-1, the GOA circuit (110) may provide the scanning signal to the pixel circuit of the (N-1)^{th} column via the output terminal (G(N-1)) of the (N-1)^{th} single-stage circuit (111). During period N, the GOA circuit (110) may provide the scanning signal to the pixel circuit of the N^{th} column via the output terminal (G(N)) of the N^{th} single-stage circuit (111).

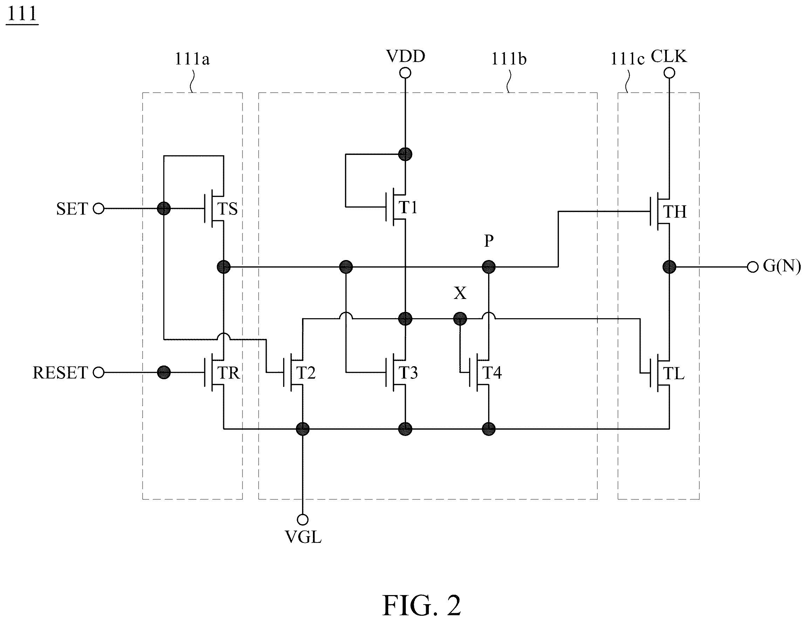

Referring to Fig. 2, Fig. 2 is a schematic diagram of an N^{th} single-stage circuit (111) according to an embodiment of the present disclosure. It should be understood that although Fig. 2 only illustrates the schematic diagram of the N^{th} single-stage circuit (111), the remaining single-stage circuits (111) also possess identical or similar circuit architectures and connection relationships. Therefore, the following description uses the N^{th} single-stage circuit (111) as an exemplary illustration.

The single-stage circuit (111) includes an input unit (111a), an intermediate circuit (111b), and an output unit (111c). The input unit (111a) and the output unit (111c) couple the first node (P) and the second node (X) in the intermediate circuit (111b). The input unit (111a) controls the potential changes at the first node (P) and the second node (X) based on the received set signal (SET) or reset signal (RESET), causing output unit (111c) to response to the potential changes at the first node (P) and the second node (X) and output either the clock signal (CLK) or the system low voltage (VGL) at the output terminal (G(N)).

The input unit (111a) includes a set transistor (TS) and a reset transistor (TR). During the set interval (P_{SET}), the set transistor (TS) receives the set signal (SET) (e.g., a high voltage level) and turns on. The potential (VP) at the first node (P) attains the high voltage level of the set signal (SET) due to the conduction of the set transistor (TS). During the reset interval (P_{RESET}), the reset transistor (TR) receives the reset signal (RESET) (e.g., a high voltage level) and turns on. The potential (VP) at the first node (P) is pulled down to the system low voltage (VGL) due to the conduction of the reset transistor (TR).

In the application of GOA circuits, the set signal (SET) may be, for example, the scanning signal output from the preceding circuit stage (i.e., the (N-1)^{th} single-stage circuit (111)), while the reset signal (RESET) may be, for example, the scanning signal output from the subsequent circuit stage (i.e., the (N+1)^{th} single-stage circuit (111)).

The output unit (111c) includes a pull-up transistor (TH) and a pull-down transistor (TL). During the set interval (P_{SET}), since the potential (VP) of the first node (P) is at a high voltage level due to the conduction of the set transistor (TS), the pull-up transistor (TH) is turned on accordingly. Upon receiving the clock signal (CLK), the pull-up transistor (TH) provides the clock signal (CLK) to the output terminal (G(N)). During the reset interval (P_{RESET}), the potential (VP) of the first node (P) is at the system low voltage (VGL) due to the conduction of the reset transistor (TR), and the potential (VX) of the second node (X) is also raised to a high voltage level. At this time, the pull-up transistor (TH) is turned off, and the pull-down transistor (TL) is turned on, thereby outputting the system low voltage (VGL) to the output terminal (G(N)).

The intermediate circuit (111b) includes a first transistor (T1), a second transistor (T2), a third transistor (T3), and a fourth transistor (T4). A first terminal and a control terminal of the first transistor (T1) are coupled to the system high voltage (VDD), and a second terminal of the first transistor (T1) is coupled to the second node (X). The first terminal and the control terminal of the first transistor (T1) are the drain terminal and the gate terminal, respectively, and both terminals share the same potential. When the system high voltage (VDD) is applied, the first transistor (T1) automatically turns on based on the voltage difference between the gate terminal and the source terminal. This causes the second node (X) to gradually charge up to a potential close to that of the gate terminal of the first transistor (T1).

By connecting the first transistor (T1) in a diode configuration, the second node (X) (i.e., the source terminal of the first transistor (T1)) is stably biased at the system high voltage (VDD) when the first transistor (T1) receives the system high voltage (VDD), thereby preventing unnecessary reverse current or leakage current phenomena.

A control terminal of the second transistor (T2) receives the set signal (SET), a first terminal of the second transistor (T2) is coupled to the second node (X), and a second terminal of the second transistor (T2) is coupled to the system low voltage (VGL). A control terminal of the third transistor (T3) is coupled to the first node (P), a first terminal of the third transistor (T3) is coupled to the second node (X), and a second terminal of the third transistor (T3) is coupled to the system low voltage (VGL). A control terminal of the fourth transistor (T4) is coupled to the second node (X), a first terminal of the fourth transistor (T4) is coupled to the first node (P), and a second terminal of the fourth transistor (T4) is coupled to the system low voltage (VGL).

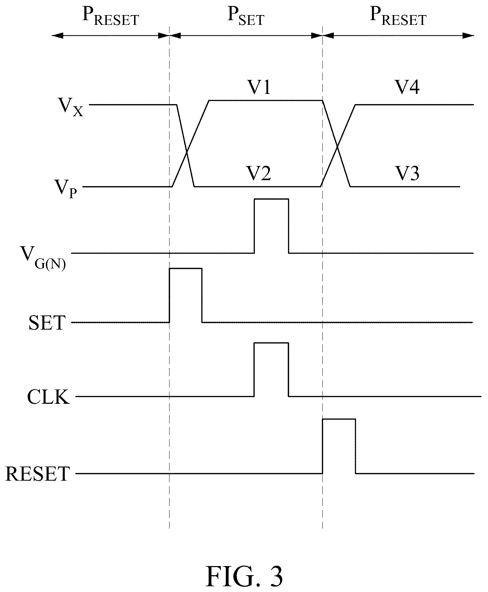

Based on the circuit architecture of the single-stage circuit (111) shown in Fig. 2, the operations of the single-stage circuit (111) in the disclosed embodiment are explained below in conjunction with the timing diagram of the states corresponding to the single-stage circuit (111) illustrated in Fig. 3. In the following, the operational interval of single-stage circuit (111) primarily includes the reset interval (P_{RESET}) and the set interval (P_{SET}).

As shown in Fig. 3, during the set interval (P_{SET}), the set transistor (TS) and the second transistor (T2) are turned on by the set signal (SET). At this time, the set transistor (TS) provides the set signal (SET) to the first node (P), causing the potential (VP) at the first node (P) to have the first voltage (V1). Meanwhile, the second transistor (T2) provides the system low voltage (VGL) to the second node (X), causing the potential (VX) at the second node (X) to have the second voltage (V2).

Correspondingly, the third transistor (T3) turns on and provides the system low voltage (VGL) to the second node (X), causing the fourth transistor (T4) and the pull-down transistor (TL) to turn off due to the second voltage (V2). By activating the set interval (P_{SET}), the pull-up transistor (TH) turns on due to the first voltage (V1) at the first node (P). This enables the single-stage circuit (111) to provide the clock signal (CLK) to output terminal (G(N)) upon receiving the clock signal (CLK), while preventing the system low voltage (VGL) from being output to terminal G(N).

During the reset interval (P_{RESET}), the reset transistor (TR) turns on upon receiving the reset signal (RESET). At this time, the reset transistor (TR) provides the system low voltage (VGL) to the first node (P), causing the potential (VP) at the first node (P) to drop from the first voltage (V1) to the third voltage (V3), which is approximately equal to the system low voltage (VGL). This action turns off the pull-up transistor (TH). Additionally, the third transistor (T3) turns off to stop providing the system low voltage (VGL) to the second node (X), thereby resetting the potential (VX) at the second node (X) from the second voltage (V2) to the fourth voltage (V4), which is approximately equal to the system high voltage (VDD). As a result, the fourth transistor (T4) and the pull-down transistor (TL) are turned on due to the high voltage level of the fourth voltage (V4), thereby outputting the system low voltage (VGL) to the output terminal (G(N)).

Based on the operating principle above, it is evident that, in addition to ensuring that the third transistor (T3) and the pull-up transistor (TH) remain stably turn on within the set interval (P_{SET}) based on the potential (VP) at the first node (P), it is also necessary to ensure that the fourth transistor (T4) and the pull-down transistor (TL) remain stably turned off based on the potential (VX) at the second node (X). This prevents the simultaneous conduction of the pull-up transistor (TH) and the pull-down transistor (TL), thereby avoiding leakage currents flowing through the fourth transistor (T4) and the pull-down transistor (TL).

Therefore, the present disclosure adjusts the width-to-length ratios of the transistors associated with the first node (P) and the second node (X) within the single-stage circuit (111) to bring the voltages at the critical nodes closer to the ideal voltage levels. This design achieves the effect of reducing leakage currents and enhancing the reliability of the single-stage circuit (111).

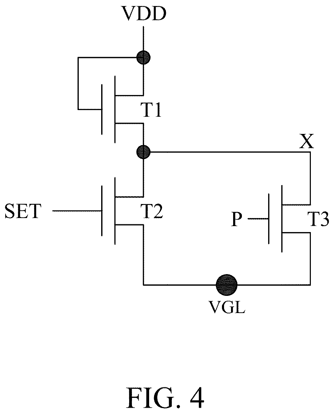

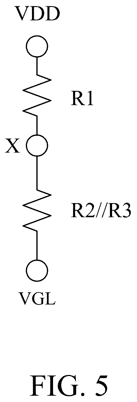

Please refer to Figs. 4 and 5 simultaneously. Fig. 4 is a schematic diagram of an equivalent circuit of the single-stage circuit (111) during the set interval (P_{SET}) according to an embodiment of the present disclosure. Fig. 5 is a schematic diagram of an equivalent impedance model in the set interval (P_{SET}) based on the equivalent circuit illustrated in Fig. 4.

As shown in Fig. 4, the equivalent circuit of single-stage circuit (111) during the set interval (P_{SET}) primarily consists of the first transistor (T1), the second transistor (T2), and the third transistor (T3). The first transistor (T1) forms a pull-up path from the system high voltage (VDD) to the second node (X) in a diode connection configuration. The second transistor (T2) and the third transistor (T3) are connected in parallel. Due to the current-limiting characteristic of the first transistor (T1) during conduction and the conduction resistance of the second transistor (T2) and the third transistor (T3) being controlled by their gate bias voltage and the channel width-to-length ratio, the entire circuit is further equivalent to the impedance model shown in Fig. 5.

As shown in Fig. 5, the first transistor (T1) is represented as having a first equivalent impedance (R1), the second transistor (T2) is represented as having a second equivalent impedance (R2), and the third transistor (T3) is represented as having a third equivalent impedance (R3). The equivalent impedances of the second transistor (T2) and the third transistor (T3) are regarded as a parallel impedance (R2//R3) of the second equivalent impedance (R2) and the third equivalent impedance (R3). Therefore, during the set interval (P_{SET}), the single-stage circuit (111) may be considered as a series structure formed by the first equivalent impedance (R1) and the parallel impedance (R2//R3).

In the disclosed design, the parallel value of the second equivalent impedance (R2) and the third equivalent impedance (R3) is specifically made significantly smaller than the first equivalent impedance (R1), which is expressed as: $\left(R2//R3\right) ≪ R 1 .$

Based on this impedance relationship, the potential (VX) at the second node (X) rapidly approaches the low voltage level during the set interval (P_{SET}), thereby stably controlling the potential (VP) at the first node (P) and the potential (VX) at the second node (X).

Furthermore, to realize the aforementioned impedance relationship in actual circuits, the present disclosure proposes an electrical matching design approach by adjusting the width-to-length ratio of the first transistor (T1), the second transistor (T2) and the third transistor (T3) (i.e. the ratio of channel width (W) to channel length (L)). In the disclosed embodiment, the product of the width-to-length ratio of the first transistor (T1) and a coefficient k is less than the sum of the width-to-length ratios of the second transistor (T2) and the third transistor (T3). This design relationship is expressed as: $k \times {\left(\frac{W}{L}\right)}_{T 1} = {\left(\frac{W}{L}\right)}_{T 2} + {\left(\frac{W}{L}\right)}_{T 3} .$

In the above relationship, the coefficient k is a positive integer. When the coefficient k is greater than or equal to 30, it ensures that the steady-state voltages of the first node (P) and the second node (X) during the set interval (P_{SET}) approach the ideal driving conditions. This effectively prevents leakage currents caused by the simultaneous conduction of the pull-up transistor (TH) and the pull-down transistor (TL), thereby stabilizing the output waveforms at the output terminal (G(N)) of the single-stage circuit (111).

For example, if the channel width of the first transistor (T1) is set to 5 micrometers (µm) and the channel length to 45 µm; the channel width of the second transistor (T2) is set to 80 µm and the channel length to 10 µm; and the channel width of the third transistor (T3) is set to 80 µm and the channel length to 10 µm; then the coefficient k is approximately 160. Therefore, the design conditions of the coefficient k being greater than or equal to 30 has been met, ensuring that the potentials at the first node (P) and the second node (X) approach the ideal potentials and that the driving waveforms at the output terminal (G(N)) remain stable and undistorted.

Conversely, if the coefficient k is less than 30, the difference in conduction capability between the first transistor (T1) and the second and third transistors (T2), (T3) becomes excessively large. Therefore, the second node (X) may fail to complete potential transition within the prescribed timing, and the first node (P) may undergo incomplete discharge due to a control delay of the third transistor (T3). Under these circumstances, the clock signal (CLK) outputted to the output terminal (G(N)) exhibits distortion or edge delay, thereby affecting the scanning operations of the subsequent stage pixel circuits.

Referring again to Fig. 3, the waveforms of the potential (VP) at the first node (P) and the potential (VX) at the second node (X) show that, during the set interval (P_{SET}) and reset interval (P_{RESET}), the voltages change at both nodes and exhibit a controlled slope difference and timing relationship based on the width-to-length ratio design of the first transistor (T1), the second transistor (T2), and the third transistor (T3) disclosed herein.

During the set interval (P_{SET}), since the parallel conduction capability of the second transistor (T2) and the third transistor (T3) exceeds that of the first transistor (T1), the potential (VX) at the second node (X) rapidly drops from the high voltage level to the second voltage (V2) first. Subsequently, the potential (VP) at the first node (P) rises to the first voltage (V1). This time difference ensures that the second node (X) stabilizes at the low voltage level before the first node (P) fully rises to the target voltage, thereby preventing leakage currents or cross-conduction caused by instantaneous conduction.

In contrast, during the reset interval (P_{RESET}), the conduction capabilities of the first transistor (T1), the second transistor (T2), and the third transistor (T3) cause the potential change to exhibit opposite trends. At this time, the potential (VP) at the first node (P) gradually decreases from the first voltage (V1) to a third voltage (V3), while the potential (VX) at the second node (X) slowly increases from the second voltage (V2) to a fourth voltage (V4). Since the falling slope of the potential (VP) at the first node (P) is greater than the rising slope of the potential (VX) at the second node (X), the first node (P) has already fully dropped to the third voltage (V3) before the second node (X) reaches the fourth voltage (V4).

The sequential relationship between the potential slopes of the first node (P) and the second node (X) ensures the accuracy and integrity of the output waveforms during the set interval (P_{SET}) and reset interval (P_{RESET}), respectively, thereby enabling the normal operations of the single-stage circuit (111).

In conclusion, the electronic paper display, the GOA circuit, and the single-stage circuit thereof disclosed herein perform parameter adjustments on the transistors associated with the critical nodes. By designing the channel width-to-length ratios and the equivalent impedance ratios of the first transistor, the second transistor, and the third transistor, the disclosed design effectively stabilizes the potentials of the critical nodes. Based on the design of the present disclosure, the potentials of the critical nodes maintain appropriate slopes and timing differences during the set interval and the reset interval. This configuration avoids leakage currents caused by simultaneous conduction of the pull-up and pull-down transistors, and ensures the stability of the waveforms outputted by the output terminal, thereby enhancing the driving stability and display quality of the electronic paper display.

## Claims

1. A single-stage circuit (111) comprising:
an input unit (111a) configured to receive a set signal (SET) within a set interval (P_{SET}), and control a first node (P) to have a first voltage (V1) and a second node (X) to have a second voltage (V2) in response to the set signal (SET);
an output unit (111c) configured to receive a clock signal (CLK) and a system low voltage (VGL), provide the clock signal (CLK) to an output terminal (G(N)) of the output unit (111c) in response to the first voltage (V1), and block the system low voltage (VGL) from the output terminal (G(N)) in response to the second voltage (V2); and
an intermediate circuit (111b) coupled between the input unit (111a) and the output unit (111c) and comprising:
a first transistor (T1), wherein a first terminal and a control terminal of the first transistor (T1) are coupled to a system high voltage (VDD), and a second terminal of the first transistor (T1) is coupled to the second node (X);
a second transistor (T2), wherein a control terminal of the second transistor (T2) receives the set signal (SET), a first terminal of the second transistor (T2) is coupled to the second node (X), and a second terminal of the second transistor (T2) is coupled to the system low voltage (VGL); and
a third transistor (T3), wherein a control terminal of the third transistor (T3) is coupled to the first node (P), a first terminal of the third transistor (T3) is coupled to the second node (X), and a second terminal of the third transistor (T3) is coupled to the system low voltage (VGL);
**characterised in that** a product of a width-to-length ratio of the first transistor (T1) and a coefficient (k) is smaller than a sum of a width-to-length ratio of the second transistor (T2) and a width-to-length ratio of the third transistor (T3), and wherein the coefficient (k) is a positive integer.

2. The single-stage circuit (111) of claim 1, **characterized in that** the coefficient (k) is greater than or equal to 30.

3. The single-stage circuit (111) of claim 1, **characterized in that** a potential at the second node (X) decreases to the second voltage (V2) before a potential at the first node (P) increases to the first voltage (V1).

4. The single-stage circuit (111) of claim 3, **characterized in that** during a reset interval (P_{RESET}), the potential of the first node (P) decreases from the first voltage (V1) to a third voltage (V3), the potential of the second node (X) increases from the second voltage (V2) to a fourth voltage (V4), and the potential of the first node (P) decreases to the third voltage (V3) before the potential of the second node (X) increases to the fourth voltage (V4).

5. The single-stage circuit (111) of claim 1, **characterized in that** during the set interval (P_{SET}), the first transistor (T1) has a first equivalent impedance (R1), the second transistor (T2) has a second equivalent impedance (R2), the third transistor (T3) has a third equivalent impedance (R3), and a parallel value of the second equivalent impedance (R2) and the third equivalent impedance (R3) is significantly smaller than the first equivalent impedance (R1).

6. The single-stage circuit (111) of claim 1, **characterized in that** the input unit (111a) comprises:
a set transistor (TS), wherein a control terminal and a first terminal of the set transistor (TS) are coupled to the set signal (SET), and a second terminal of the set transistor (TS) is coupled to the first node (P).

7. The single-stage circuit (111) of claim 6, **characterized in that** the input unit (111a) further comprises:
a reset transistor (TR), wherein a control terminal of the reset transistor (TR) is coupled to a reset signal (RESET), a first terminal of the reset transistor (TR) is coupled to the first node (P), and a second terminal of the reset transistor (TR) is coupled to the system low voltage (VGL).

8. The single-stage circuit (111) of claim 1, **characterized in that** the output unit (111c) comprises:
a pull-up transistor (TH), wherein a control terminal of the pull-up transistor (TH) is coupled to the first node (P), a first terminal of the pull-up transistor (TH) is coupled to the clock signal (CLK), and a second terminal of the pull-up transistor (TH) is coupled to the output terminal (G(N)).

9. The single-stage circuit (111) of claim 8, **characterized in that** the output unit (111c) further comprises:
a pull-down transistor (TL), wherein a control terminal of the pull-down transistor (TL) is coupled to the second node (X), a first terminal of the pull-down transistor (TL) is coupled to the output terminal (G(N)), and a second terminal of the pull-down transistor (TL) is coupled to the system low voltage (VGL).

10. The single-stage circuit (111) of claim 1, **characterized in that** the intermediate circuit (111b) further comprises:
a fourth transistor (T4), wherein a control terminal of the fourth transistor (T4) is coupled to the second node (X), a first terminal of the fourth transistor (T4) is coupled to the first node (P), and a second terminal of the fourth transistor (T4) is coupled to the system low voltage (VGL).

11. An electronic paper display (100) comprising:
a display panel (120); and
a gate driver on array circuit (110) configured to drive the display panel (120), **characterised in that** the gate driver on array circuit (110) comprises a plurality of single-stage circuits (111) according to any one of claims 1 to 10, wherein the plurality of single-stage circuits (111) are electrically connected in series with each other.

12. A gate driver on array circuit (110) comprising:
a plurality of circuit stages electrically connected in series with one another, **characterised in that** each of the circuit stages comprises a single-stage circuit (111) according to any one of claims 1 to 10.
